# EUROPEAN PATENT APPLICATION

(11) **EP 1 816 891 A1**
(43) Date of publication of application: **08.08.2007**
(21) Application number: 04799571.7
(22) Date of filing: 10.11.2004
(51) Int. Cl.: H04R 1/20, H03G 3/20

(54) **SOUND ELECTRONIC CIRCUIT AND METHOD FOR ADJUSTING SOUND LEVEL THEREOF**

(71) Applicant: Sekiguchi, Hiroshi, Nakano-ku Tokyo 1650024 (JP)
(72) Inventor: Sekiguchi, Hiroshi, Nakano-ku Tokyo 1650024 (JP)
(74) Representative: Roth, Klaus
(86) International application number: PCT/JP2004/016673
(87) International publication number: WO 2006/051586

(57) **Abstract**

In a device that reproduces sounds, which are to be presented to listeners, from sound electric signals received from a sender, such as a television, radio, mobile telephone or the like, or from sound electric signals recorded on a sound information recording medium, even if the loudness level is so established beforehand by the listeners as to allow them to easily listen to the reproduced sounds, the loudness level, which is actually perceived by the listeners, i.e., the sensuous loudness level may be unstable due to the original loudness levels or types included in sound electric signals. The present invention relates to a loudness level adjusting method and the like for allowing the sensuous loudness level to be adjusted such that it always becomes generally stable regardless of any original loudness levels or types. In order to adjust the loudness level of a sound electric signal to be reproduced, an electronic circuit is provided in a stage preceding a speaker or the like that converts the sound electric signal to sound waves that are audible to human ears. This electronic circuit uses a frequency dividing device, a RMS value extracting device and the like to extract, as an alternating current component of the sound electric signal, at least one element information signal. The electronic circuit has a sensuous loudness level signal generating device, which includes a smoothing device, a weighting device and the like, for generating a sensuous loudness level signal from the element information signal, and further has a loudness level control device for automatically adjusting the loudness level such that any level of sounds received from the sender always becomes an easy-to-listen loudness level established by the listeners.

## Description

### Technical Field

The present invention relates to a sound electronic circuit provided in a stage preceding a converter such as speaker and earphone which converts sound electric signals such as music and voices into sound waves audible to human ears, and to a loudness level adjusting method for the sound electronic circuit.

### Background Art

Examples of known information providing measures include TV broadcast and radio broadcast which provide one-directional information from a broadcasting station to an unspecified number of audience. According to the communication system of these broadcasts, an audience generally receives information provided from a broadcasting station by using a receiving device (television or radio). Particularly, in the information providing measures such as broadcast or the like, information is provided one-directionally from the broadcasting station to the audience, and therefore the loudness level actually perceived by the audience does not always become stable due to change of the contents or scenes in the broadcast even if the audience establishes the loudness level of the broadcast for reproduction beforehand. Thus, the audience is required to re-adjust the loudness level when the audience desires to obtain an easy-to-listen loudness level.

According to communication over telephone which is one of the most typical measures providing one-to-one exchanges of information, some speak in a low and whispering voice and thus cannot be easily heard, and others speak in a loud voice. Thus, it is necessary to re-adjust the loudness level for each phone call if these voices are to be easily heard at all times. Actually, many people do not adjust the loudness level even when they cannot easily hear voices over the phone since loudness level adjustment operation is troublesome.

For providing more comfortable communication in view of loudness level, Patent Reference No. 1 discloses a technology which automatically adjusts the level of sounds to an optimum level when the loudness level having been set and fixed on the receiver side changes due to types or conditions of received TV signals.
Patent Reference No. 1: JP-A-2002-369097

### Disclosure of the Invention

### Problems that the Invention is to Solve

The inventor closely examined the use of an electronic circuit of an information processing device which has a structure for reproducing and outputting sound electric signals received from known media such as television, radio and telephone or media on which sounds are recorded, and found the following problems.

For example, when a listener listens to sounds from a receiving device such as television and radio, he or she has experiences that the sounds are too loud every time the scene changes or that voices from a person is difficult to hear even when the loudness level is fixed. Under the condition where the loudness level is adjusted to a comfortable loudness level for the scene including only human voices such as a news program, for example, the sounds become "loud" in some cases when the scene is shifted to a commercial or other scenes including other sounds such as musical sounds. On the contrary, under the condition where the loudness level is set at a level appropriate for scenes including sounds other than voices such as dramas containing background music or for battle scenes in a war film, reproduced voices are too low and difficult to be heard in some cases when the scene is shifted to a scene containing only voices.

This is because the level of sounds, particularly the level of "loudness", differs depending on the components of the sounds according to the characteristics of the human sense of hearing even when sound information is provided from the broadcasting station side to the receiver side at a constant loudness level. The technology disclosed in Patent Reference No. 1 automatically controls the loudness level on the receiver side. However, this method only reduces fluctuations in the signal level caused by the variations in the receiver's environment or different receiving channels, and does not control the sensuous loudness level for the listener who actually listens to the sounds.

There are the following specific cases known from experiences where fluctuations in the sensuous loudness level are caused: (1) the case where sounds are "loud" when a commercial starts in the middle of a program containing only voices such as a news program; (2) the case where sounds are extremely loud when a scene containing musical sounds such as a commercial or a scene containing a battle of a war movie starts under the condition where the minimum loudness level is set at a level necessary for perceiving only voices in a quiet environment such as in the middle of night; (3) the case where voices are difficult to be heard when the scene is shifted to a quiet scene containing only voices under the condition where the loudness level is set at a level appropriate for scenes containing loud background sounds at the time of film watching on videos; (4) the case where the allowable range of loudness levels comfortable for an aged person who has poor hearing ability is narrowed; and other cases.

In case of telephone, since some person in communication on the phone speaks in a loud voice and other person speaks in a low and whispering voice, the loudness level is not always adjusted to a desirable level for the person hearing the voices. In addition, such a case is well known where the same person speaks in a loud voice when he or she is in a crowd and speaks in a low voice when surrounded by other people, resulting in considerable fluctuations in loudness level. In such cases, the person hearing the voices cannot adjust the loudness level every time the loudness level varies, and thus feels inconvenience.

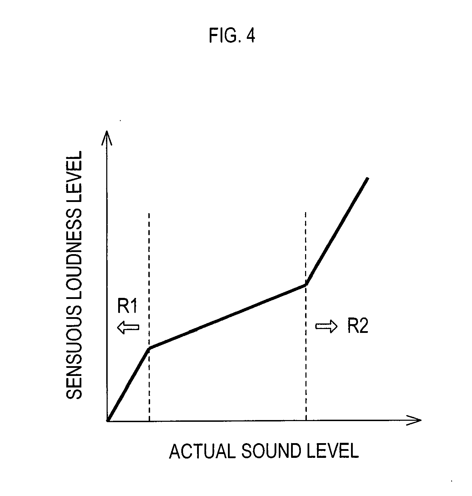

As shown in Fig. 4, according to an allowable loudness level range with respect to comfortable and uncomfortable feelings, the sensuous loudness level changes more largely than the actual loudness level in a range R1 close to the audible limit. Thus, sounds become extremely difficult to be heard when the loudness level is slightly decreased, and sounds become too loud when the loudness level is slightly increased in the range R1. This is easily understood from the condition where a person is watching a TV program while setting a reduced loudness level in the middle of night or from other past experiences.

On the contrary, under the condition where the loudness level is increased to a level immediately before the level of "loudness" (uncomfortable level), the listener feels uncomfortable only when the loudness level is slightly increased or only when slightly noisy sounds are mixed. There is also a great difference between the change of the actual loudness level and the change of the sensuous loudness level in a range of R2 shown in Fig. 4.

The sensuous loudness level mentioned above is a physical quantity which chiefly quantifies the "loudness" felt by humans using indexes. For example, Fig. 4 is a qualitative graph showing the generally recognized relationship between the actual loudness level and the sensuous loudness level based on experiences. This graph shows that the change of the sensuous loudness level becomes more prominent at the low loudness level (range R1 in Fig. 4) and the high loudness level (range R2 in Fig. 4) than in the ordinary comfortable loudness level range.

Another problem concerning the level of sounds transmitted from information processing devices to humans is that the surrounding noise level considerably differs according to the environment of the receiver of the sounds in such cases as cellular phones. That is, the same loudness level is so low that the voices are difficult to hear or so high that the voices give damage to ears depending on the level of the noise. This is also a problem regarding the level of sounds produced from information processing devices to be heard by humans.

The invention has been developed to solve the above problems. It is an object of the invention to provide a sound electronic circuit and a sound adjusting method which automatically adjusts sensuous loudness level of sound information actually felt by a listener to a reference loudness level by establishing the reference loudness level of the sound information provided by wire or radio to a loudness level comfortable for the listener of the sound information on the receiver side no matter how the loudness level of the sound information or the surrounding noise changes.

The sound electronic circuit according to the invention is an analog signal processing circuit or a digital signal processing circuit for loudness level control provided in a stage preceding a speaker, an earphone or other converter which converts sound electric signals such as music and voice into sound waves audible to human ears. The sound electronic circuit is capable of reproducing and outputting sound information contained in contents delivered to television, radio, cellular phone, personal computer (PC) or the like by wire or radio or outputted from an information recording medium.

### Means for Solving the Problems

The invention has been developed by the inventor who found from his investigation that an element of "loudness" of sound felt by humans relates not only to sound wave amplitude information or RMS(root mean square) value of electric waveform, but also to various types of element information signals as alternating signals such as energy distributions on a frequency axis. For example, even when a sound electric signal has the same level based on amplitude information, "loudness" (sensuous loudness level) of the sound felt by a person listening to the sound differs due to different frequency components included in the signal. Thus, according to the invention, the sensuous "loudness" value is extracted for every moment by using various types of element information signals as alternating signals such as frequency components as well as using the physical quantity obtained from the amplitude information of the sound electric signal, and the loudness level is automatically adjusted at every moment to make the sensuous "loudness" value as close as possible to the reference level set by the listener.

A loudness level adjusting method for a sound electronic circuit according to the invention includes an sensuous loudness level signal generating step that includes a smoothing step and generates an sensuous loudness level signal indicating sensuous loudness level of a sound electric signal based on an element information signal extracted by an element information signal extracting step as an alternating signal from the sound electric signal to be reproduced and outputted, and a loudness level controlling step that adjusts the loudness level of the sound electric signal to be reproduced and outputted such that the sensuous loudness level of the sound electric signal within a reproduction output period approaches a loudness level reference established by the listener as close as possible based on the generated sensuous loudness level signal.

By the loudness level adjusting step, the sensuous loudness level is kept substantially constant in any sound scenes including switching between reproduced scenes of the sensuous electric signals and such conditions as background music is gradually increasing during reproduced scenes. When the electronic circuit is an analog signal processing circuit, the sensuous loudness level signal is handled as an analog signal. When the electronic circuit is a digital signal processing circuit, the sensuous loudness level signal is handled as a digital signal.

The smoothing step included in the sensuous loudness level signal generating step is also an important factor of the invention. The sensuous loudness level such as loudness and level of sounds practically felt by humans is based not on level of sound wave at an instant but on an accumulation of sound waves perceived by human ears for a certain time period. It is therefore essential to include a smoothing device so as to process not an element information signal for every moment but an average value of the element information signals for a certain time period.

The element information signal extracting step can extract the element information signal without dividing the sound electric signal by a plurality of bands. More specifically, the sensuous loudness level signal generating step has a filtering device that has gain characteristics approximately proportional to a frequency of an analog or digital sound electric signal, and a pseudo energy component as an output signal from the filtering device can be used as the element information signal.

The filtering device is constituted by a filter which gives larger gains for higher frequency (high range emphasizing filter). A signal produced by smoothing pseudo energy components (RMS or the like) of a signal having passed through the high range emphasizing filter becomes a signal substantially proportional to the sensuous loudness level perceived by human ears. When the loudness level of the signal thus obtained is higher than the loudness level reference established by the listener, the loudness level of the sound electric signal to be reproduced and outputted is reduced. When the loudness level of the signal is lower than the loudness level reference, the loudness level of the sound electric signal to be reproduced and outputted is increased for control.

The loudness level adjusting method according to the invention is a loudness level adjusting method for adjusting a loudness level of a sound electric signal to be reproduced by a predetermined reproduction device. This loudness level adjusting method is executed by the above-described electronic circuit (electronic circuit according to the invention) or under a computer program. More specifically, the loudness level adjusting method according to the invention generates an sensuous loudness level signal indicating sensuous loudness level of the sound electric signal based on the element information signal extracted from the sound electric signal to be reproduced, and controls the loudness level of the sound electric signal to be reproduced and outputted such that the sensuous loudness level of the sound electric signal approaches the loudness level reference established by the listener as close as possible based on the generated sensuous loudness level signal.

Particularly, according to the loudness level adjusting method of the invention, the following steps may be performed. The frequency of the analog or digital sound electric signal is divided into a plurality of frequency bands. Then, pseudo energy components corresponding to energy for each of the divided bands are extracted. Subsequently, the extracted pseudo energy components for each of the frequency bands are weighted. Thereafter, the weighted components are combined into a signal and smoothed for each of the bands to generate the sensuous sound signal as element information signal.

The extracting device that extracts pseudo energy components for each band may use fast Fourier transformation.

According to the loudness level adjusting method of the invention, the sensuous loudness level signal may be generated by preparing a filter which has gain characteristics approximately proportional to sensuous loudness level of an analog or digital sound electric signal on the frequency axis and extracting pseudo energy components of an output signal from the filtering device as an element information signal.

According to the above loudness level adjusting method, when the frequency width of the sound source is narrow in such a case as telephone or when low quality of loudness level adjustment is allowable, the sensuous loudness level signal can be generated by using only either an average amplitude information signal or RMS information signal as the element information signal.

The above-described loudness level adjusting method may be a program executed by a computer or the like. In this case, this program may be provided through a network either by wire or by radio. Alternatively, the program may be stored in an information recording medium such as CD, DVD and flash memory.

In the above method, the sensuous loudness level signal is controlled to be as close as possible to the loudness level reference set by the listener. However, the loudness level reference may be increased or decreased according to the surrounding noise level around the listener. When the surrounding noise level is high as in a crowd, for example, the loudness level reference may be automatically increased in accordance with the noise level.

Respective embodiments according to the invention will be further fully understood from the following detailed description and the appended drawings. These embodiments are only examples, and therefore should not be considered as what limits the invention.

Further applications of the invention will be apparent from the following detailed description. However, the detailed description and specific examples showing preferred embodiments according to the invention are only examples, and it is therefore apparent that various modifications and improvements within the spirit and scope of the invention are easily made by those skilled in the art from the detailed description. Advantage of the Invention

According to the invention, therefore, an sensuous loudness level signal as physical quantity corresponding to the sensuous loudness level practically perceived by humans is extracted as loudness level information of a sound electric signal prior to reproduction, and the loudness level is controlled to become an optimum level in accordance with the level of surrounding sounds. Thus, the sensuous loudness level practically felt by human ears can be automatically kept substantially constant even loudness of sound information frequently changes. A user of a cellular phone to which the invention is applied can listen to voices having a loudness level desired and established and by himself or herself and automatically controlled as appropriate for the surrounding noise level no matter what quality of voices the person in communication by the phone is. Thus, a certain degree of listening easiness can be secured at all times. In a third embodiment in paragraphs No. 56 through No. 89 in the following description, the inventor customized constants used in this embodiment such that they become optimum values for television, and executed simulations on a personal computer. Similarly, the inventor executed experiments for customizing the constants such that they are optimized for telephone. According to the results from these experiments, all listeners of the sample sounds confirmed that remarkable advantages are provided for both television and telephone. Sounds obtained from the simulations on the personal computer have been recorded on CD-DA. Since sounds before application of the invention are recorded on the CD-DA as well as the sounds after application of the invention, comparison between these two types of sounds can be made in listening.

### Brief Description of the Drawings

[Fig. 1] Fig. 1 illustrates a structure of a sound electronic circuit and a loudness level adjusting method for the sound electronic circuit in an embodiment according to the invention.
[Fig. 2] Fig. 2 illustrates an example of a specific hardware structure used for executing the loudness level adjusting method according to the invention.
[Fig. 3] Fig. 3 is a flowchart showing the loudness level adjusting method according to the invention.
[Fig. 4] Fig. 4 is a graph showing a relationship between an actual loudness level and an sensuous loudness level based on experience.
[Fig. 5] Fig. 5 illustrates a third embodiment according to the invention as a block diagram showing software processing performed by the hardware shown in Fig. 2.
[Fig. 6] Fig. 6 is a graph for calculating K from sRq and a table showing three formulae for calculating K from sRq for three regions in the graph in the third embodiment.
[Fig. 7] Fig. 7 is a block diagram showing a general idea of processing performed by a DSP in a fourth embodiment.
[Fig. 8] Fig. 8 is a block diagram showing the fourth embodiment.
[Fig. 9] Fig. 9 is a graph showing a relationship between a sample & hold signal and a reset signal generated from a timing signal generating device.
[Fig. 10] Figs. 10(a) and 10(b) are block diagrams showing a fifth embodiment.
[Fig. 11] Fig. 11 is a graph showing a fluctuation relationship between sRq as logarithm and a loudness level specifying digital signal.

### Description of Reference Numerals and Signs

- 1: television
- 2: radio
- 3: cellular phone
- 4: personal computer (PC)
- 10: sound reproducing circuit
- 11: volume control
- 12: amplifier
- 13: speaker
- 20: loudness level adjusting circuit
- 21: frequency dividing device
- 22: RMS processing element
- 23: function processing element
- 24: weighting element
- 25: combining device
- 26: switch (SW)
- 27: comparing device
- 28: amplitude control device
- 31: analog/digital converter (A/D)
- 32: digital signal processing section (DSP)
- 33: digital/analog converter (D/A)
- 34: recording device (ROM)
- 35: recording device (RAM)
- 36: sensuous loudness level signal generating device
- 37: modification coefficient calculating device
- 38: interpolating device
- 39: FIFO register
- 40: amplitude modifying device
- 41: graph showing value Kq when sRq is smaller than X
- 42: graph showing value Kq when sRq is X or larger and smaller than Y
- 43: graph showing value Kq when sRq is Y or larger
- 44: point of value when sRq is large value L1
- 45: point of value when sRq is modified to desirable value
- Z:
- 46: line showing virtual value sRq of loudness level after processing
- 47: point of value Kq generated when sRq is large value L1
- 48: range of sRq smaller than X on horizontal axis
- 49: range of sRq equal to or larger than X and smaller than Y on horizontal axis
- 50: range of sRq equal to or larger than Y on horizontal axis
- 51: point of sRq corresponding to L1 on horizontal axis
- 52: microphone
- 53: amplifier
- 54: rectifying device
- 55: smoothing device

- 56: timing signal generating device
- 57: minimum loudness level signal holding device
- 58: S&H device
- 59: multiplexer
- 60: analog/digital converter (ADC)
- 61: digital signal processor (DSP)
- 62: digital/analog converter (DAC)
- 63: read-only memory (ROM)
- 64: random-access memory (RAM)
- 65: surrounding noise signal
- 66: sound circuit
- 67: electronic volume control
- 68: amplifying circuit
- 69: loudness level specifying digital signal
- 70: added part for keeping sensuous loudness level constant
- 71: analog/digital converter (ADC)
- 72: digital signal processor (DSP)
- 73: read-only memory (ROM)
- 74: random-access memory (RAM)

### Best Mode for Carrying Out the Invention

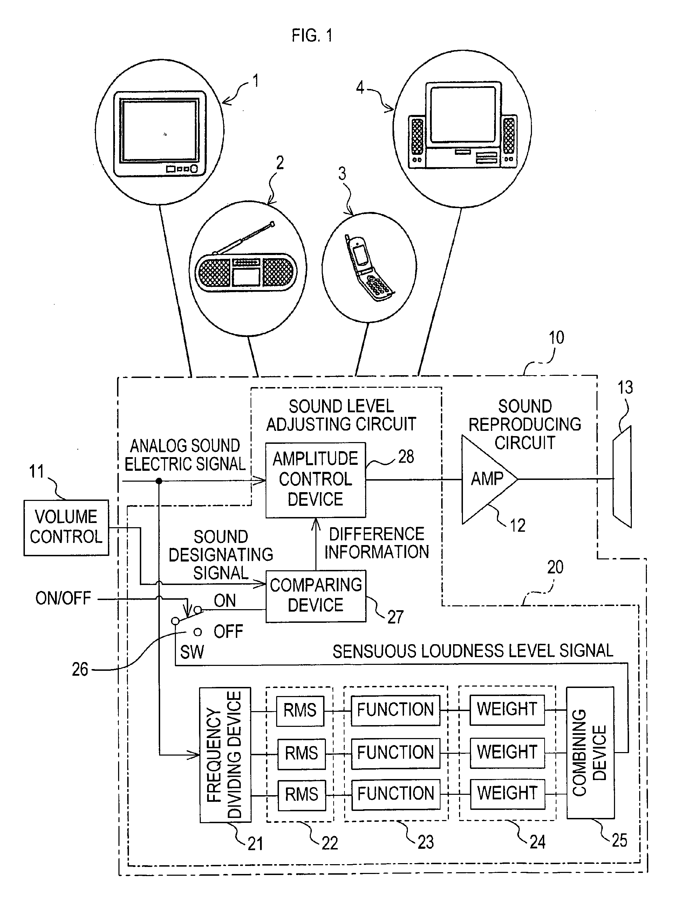

Respective embodiments of a sound electronic circuit and a loudness level adjusting method according to the invention are hereinafter described in detail with reference to Figs. 1 through 11. In the following description referring to the figures, the same numerals are given to the same parts and elements, and the explanation is not repeated. The sound adjusting method according to the invention may be either an analog signal processing method or a digital signal processing method.

Fig. 1 illustrates a structure of a sound electronic circuit and a sound adjusting method for the sound electronic circuit in an embodiment according to the invention. The figure particularly shows a structure example of a sound signal reproducing circuit including a loudness level adjusting device for adjusting loudness level of sound information.

A sound reproducing circuit 10 may be either an analog signal processing circuit or a digital signal processing circuit. The sound reproducing circuit 10 includes a loudness level adjusting circuit 20 provided in a stage preceding a speaker, an earphone or other converter for converting a sound electric signal such as musical sound and voice into sound waves audible to human ears. The loudness level adjusting circuit 20 is applied to a sound electronic circuit having a structure for reproducing and outputting sound information contained in contents delivered to a television 1, a radio 2, a cellular phone 3, a PC 4 or the like by wire or radio.

According to a typical sound reproducing circuit included in an electronic circuit of an information processing device such as the television 1, an analog sound electric signal having a loudness level established by a volume control 11 in advance is amplified by an amplifier 12 (Amp), and then the amplified signal is reproduced and outputted from a speaker 13 as sound waves audible to human ears. The electronic circuit 10 for adjusting the loudness level according to the invention is provided in a stage preceding the converter such as the speaker 13, and includes an sensuous loudness level signal generating device, a comparing device 27, and an amplitude control device 28.

The sensuous loudness level signal generating device has a frequency dividing device 21 and a RMS value extracting device 22 as an element information signal extracting device. The sensuous loudness level signal generating device generates an sensuous loudness level signal based on extracted RMS value information and frequency information. The comparing device 27 compares the sensuous loudness level signal and a loudness level designating signal designated from the outside (volume control 11) beforehand. The amplitude control device 28 controls loudness level of an analog sound electric signal to be reproduced and outputted based on difference information indicating the difference between the sensuous loudness level signal and the loudness level designating signal.

The sensuous loudness level signal generating device further includes a smoothing device 23 for smoothing an output signal from the element information signal extracting device, a weighting device 24 for weighting the smoothed signal in each frequency band, and a combining device 25 for combining the weighted signal. The frequency dividing device 21 divides the frequency of the sound electric signal into a plurality of frequency bands. The RMS value extracting device 22 extracts pseudo energy components from each of the divided bands. The smoothing device 23 smoothes the pseudo energy components extracted from each band at each instant to equalize the pseudo energy components within a predetermined time interval. The weighting device 24 weights the smoothed signals. The combining device 25 combines the outputs from the weighting device 24 (by superposing or adding respective output signals) for each band, and outputs the resultant signal as the sensuous loudness level signal.

According to the embodiment shown in Fig. 1, a switch 26 (SW) is provided between the combining device 25 and the comparing device 27 to which the sensuous loudness level signal is transmitted from the combining device 25 as the output signal. This switch 26 is equipped because the automatic control of the sensuous loudness level is rather bothersome for the types of sounds which give importance to the dynamics of sounds such as classical music. It is possible to directly control the loudness level using the amplitude control device 28 based on the sensuous loudness level signal. In this case, the comparing device 27 is unnecessary.

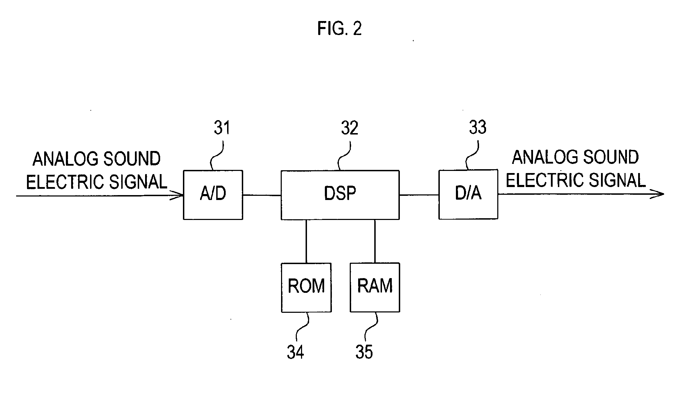

Fig. 2 illustrates an example of a specific hardware structure which is used to provide the electronic circuit of the invention as a digital signal processing circuit. More specifically, the electronic circuit shown in Fig. 2 is used to provide the loudness level adjusting circuit 20 shown in Fig. 1.

The electronic circuit includes an analog/digital converter 31 (A/D) for converting an analog sound electric signal to be reproduced into a digital signal, a digital signal processor 32 (DSP) as a controller which executes the loudness level adjusting method according to the invention to control specific loudness levels, a ROM 34 as a recording device for storing programs or the like to be executed in advance, a RAM 35 functioning as operating area and FIFO, and an analog/digital converter 33 (D/A) for converting the digital sound electric signal after loudness level adjustment into an analog sound electric signal.

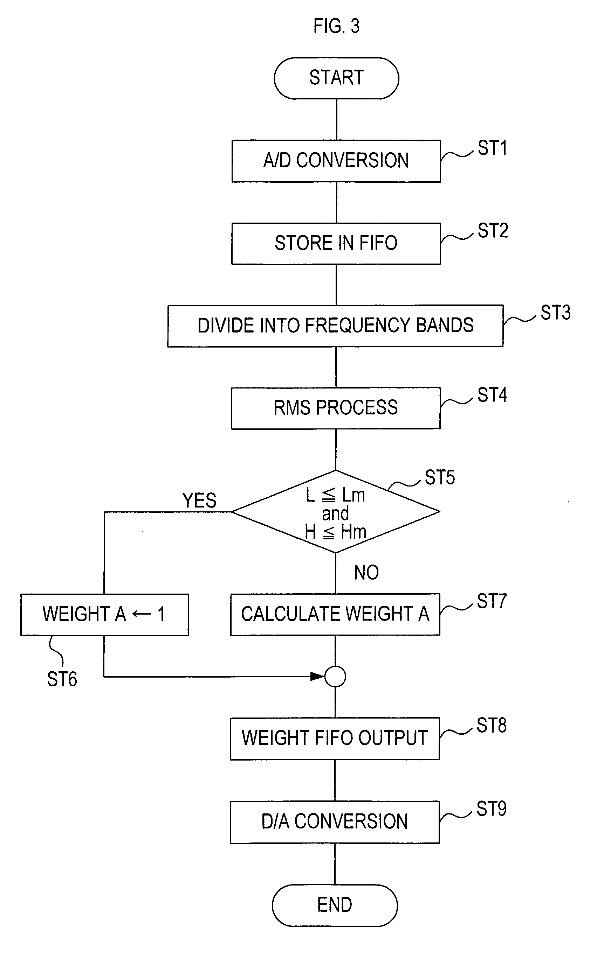

An example of digital processing according to the loudness level adjusting method of the invention is now described. Fig. 3 is a flowchart showing a method for dividing the frequency of the digitized sound signal into plural frequency bands for processing as the loudness level adjusting method (in case of digital signal processing) according to the invention.

Initially, an analog sound electric signal generated for reproduction in the sound reproducing circuit 10 is sequentially digitized by the A/D 31 (step ST1), and temporarily stored in the FIFO (step ST2). The FIFO delays a sound signal so as to match the timing of the sound signal with the timing of the extraction of an element information signal delayed due to signal processing or other reasons. In this example, loudness level adjustment is performed for a sound digital signal delayed about 100 ms. The process of the frequency band division transition executed by the DSP 32 produces about 200 ms delay, and therefore the loudness level of the sound signal is controlled according to an sensuous loudness level signal processed based on signals generated from 100 ms prior to the time for storing in the FIFO to 100 ms after the storing time. In this case, a sound produced 100 ms after a scene containing a sudden shot of a gun is included in the range of the process target. Thus, the loudness level can be controlled even when the loudness level suddenly changes.

Delaying the sound signal by using the FIFO is not an essential factor in the invention. This process is performed so that the listener can listen to the sound signal in more comfortable manner. When the FIFO is not included, there is a possibility that the control for lowering the loudness level is not executed in time for an instant when the loudness level is suddenly raised. As a result, large sound without control is outputted for just an instant. In this case, however, a serious problem is not caused for practical use where sudden large sound is not often produced during use. Thus, the FIFO can be eliminated for an inexpensive device.

The frequency of the digitized sound electric signal is divided between high frequency band and low frequency band with the boundary of 500Hz (step ST3), and RMS processing for extracting a pseudo energy component corresponding to an energy component for each of the divided bands is executed (step ST4). By this process, a RMS value H of the pseudo energy component in the high frequency band and a RMS value L of the pseudo energy component in the low frequency band can be obtained.

Subsequently, it is determined whether the loudness level adjusting method according to the invention is to be executed or not based on the obtained RMS values H and L. More specifically, comparison between the RMS value H and the threshold value Hm established beforehand and comparison between the RMS value L and the threshold value Lm are executed (step ST5). When the RMS values H and L are the threshold values Hm and Lm or lower, it is determined that the level adjustment is not particularly necessary and a weight A is set at 1 (step ST6). When at least either the RMS value H or the RMS value L exceeds the threshold value Hm or Lm, a ratio of the RMS value H in the high frequency band to the RMS value L in the low frequency band (H/L) is set at two allowable levels B1 and B2 (<B1), and function processing is performed according to the respective allowable levels.

When (H/L)≤B1, C1/(L+e₁×H) is set as the weight A. When B1<(H/L)≤B2, C2/(L+e₂×H) is set as the weight A. When B2<(H/L), C3/(L+e₃×H) is set as the weight A.

The values C1 through C3 are coefficients for adjusting the weight A to an appropriate scalar quantity. The values e₁ through e₃ are coefficients for controlling the influencing degree of the RMS value H such that the weight A decreases as the RMS value H increases.

The output (digital sound electric signal) from the FIFO is weighted with the weight A obtained from the above processing (step ST8), and the output weighted with the weight A is sequentially converted into the analog sound electric signal by the D/A 33 (step ST9).

According to the method in the first embodiment, the frequency of the sound electric signal converted into the analog or digital signal is divided into a plurality of frequency bands and the function processing is applied to each of the bands. It is possible, however, to adjust the loudness level without dividing the sound electric signal. This method is now described in the following second embodiment.

In the second embodiment according to the invention, the sensuous loudness level generating device may include filter device which varies gains on the frequency axis relative to the loudness level comfortableness degree of the sound electric signal, and energy component extracting device which extracts the pseudo energy components of the output signal from the filter device as the sensuous loudness level signal.

In this case, the filter device is a filter which produces larger gains at the higher frequency (high frequency emphasizing filter), for example. The pseudo energy component (RMS or the like) of the signal having passed through the high frequency emphasizing filter becomes a signal which varies with approximately inverse proportion to the comfortableness degree of sounds for human ears. The comfortableness degree for humans can be maintained substantially constant by decreasing the loudness level of the analog sound electric signal reproduced and outputted when the signal thus obtained is large, and by increasing the loudness level of the analog sound electric signal when the signal is small.

However, the level of the analog sound electric signal simply becomes constant in the high-tone range when the loudness level is simply adjusted to a level in accordance with the signal indicating the comfortableness. Thus, non-linear function processing is necessary for appropriate loudness level adjustment. More specifically, the loudness level control is not executed when the value of the signal indicating the comfortableness is lower than a first allowable level L1, loudness level adjustment for decreasing the loudness level by m(dB) is necessary when the value of the signal exceeds a first allowable level L1, and loudness level adjustment for decreasing the loudness level by n(dB)(>m) is necessary when the value of the signal exceeds a second allowable level L2 (<L1).

A loudness level adjustment method in a third embodiment according to the invention is now described. Similarly to the loudness level adjustment method in the first embodiment, the loudness level adjustment method in the third embodiment is executed by the electronic circuit shown in Fig. 2 for providing the loudness level adjusting circuit 20 shown in Fig. 1.

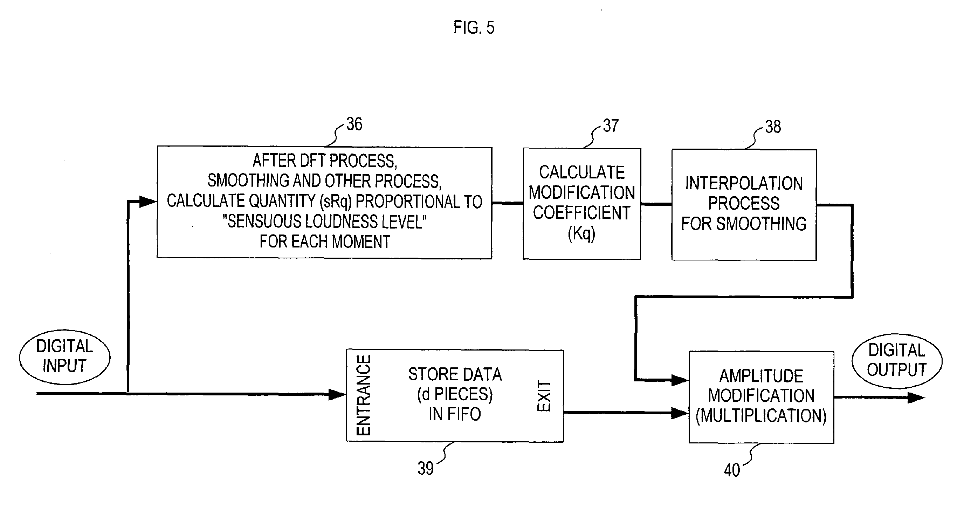

Fig. 5 is a block diagram showing the concept of the processing in the third embodiment which is performed by the DSP 32 shown in Fig. 2. The inputted digital signal is introduced into two processing devices. In one route, the digital signal is introduced to an sensuous loudness level signal generating device 36 which generates the sensuous loudness level signal to extract and smooth the element information signal including frequency information. In the other route, the digital signal is introduced to the FIFO which gives time delay to the digitized sound signal for adjustment to the time delay produced by the sensuous loudness level generating device 36. After the process by the sensuous loudness level signal generating device 36, a modification coefficient Kq is calculated by a modification coefficient calculating device 37. After the coefficient Kq is smoothed by an interpolating device 38, the digital signal delayed by the FIFO 39 is multiplied by the smoothed coefficient Kq by an amplitude modifying device 40 to modify the amplitude. Then, the digital signal is outputted from the DSP 32. This processing is now discussed in detail in the order of steps to be executed.

Initially, digital FFT process, i.e., DFT is applied to the sound electric signal inputted in the form of digital signal in the sensuous loudness level signal generating device 36. For explaining more specifically, specific values are shown in the description of the basic parts. These values are only examples, and therefore other values may be used depending on the characteristics of the devices in actual cases.

It is assumed that the sampling rate of sound digitization is 22.05K sample/sec. When the device of data to which DFT is applied is a mass of 256 data, for example, the time range of this mass becomes 11.6 milliseconds. In this case, the interval of frequency is about 86Hz due to the characteristics of DFT. The subsequent mass is 256 data shifted from the original data by 128 data. Thus, the device of advance of the data mass on the time axis is 5.8 milliseconds. When the mass of data is created, windowing having a form other than a rectangular form is generally performed. Since the windowing process is not the essential factor of the invention, this process is not explained herein.

A RMS value Ipq for each frequency band is calculated from the square root of the sum of squares of the values of the real and imaginary terms in each frequency band based on the result of DFT of each data mass. The value p is the interval number on the frequency axis from the lowest value in the result of DFT. In this example, the interval number ranges from first to 116th. Thus, the frequency Fp of the pth bundle is px86Hz. The intensity (vertical axis) of this mass is Ip. The value q is the number of the mass created by execution of DFT on the time axis.

Subsequently, the values Ipq are grouped into masses of the interval p on the frequency axis in three ranges of low, middle and high ranges per the number q on the time axis. A constant b indicating the boundary between the low range and the middle range is established, and the values from p=1 up to the value p=(b-1) are defined as a mass in the low range. Then, all the intensities (vertical axis) Ip included within this range are added and a sum Lq of these intensities is obtained. This value Lq represents the qth RMS value on the time axis in the low range.

The values from p=b up to p=(c-1) on the frequency axis are defined as a mass in the middle range. The values Ipq included within this range are all added and the sum of these values Mq is similarly obtained. The value c herein is a constant indicating the boundary between the middle range and the high range.

The values from p=c up to p=116 on the frequency axis are defined as a mass in the high range. The values Ipq included within this range are all added and the sum of these values Hq is obtained. In this case, p=117 or higher values are not used.

Weighting constants α, β, γ are prepared, and the values Lq, Mq and Hq are multiplied by the weighting constants α, β, γ, respectively, to execute weighting process and obtain a value Rq corresponding to the instant sensuous loudness level of the qth bundle on the time axis. Thus, an equation Rq = α×Lq + β×Mq + γ×Hq holds.

As obvious from the above, the numbers of the frequency bands Fp included in Lq, Mq and Hq as the result of DFT to be added are different for each of Lq, Mq and Hq, and therefore the weights are not the same from the beginning. Moreover, the number of the included frequency bands Fp varies according to the constants b and c. Thus, the weighting constants α, β, γ are established considering the original weights which are different for each band.

The loudness level according to the general idea is not the level of sounds at an instant but the level of sounds perceived in a certain time range. However, since the value Rq indicating the instant sensuous loudness level is produced for every 128 data, which is every 5.8 ms, this time range as the process target is too narrow to represent the level of sounds perceived by humans. Thus, the values Rq arranged on the time axis are smoothed, and the average in the certain time range is captured. However, the response speed decreases when the row of the values Rq is smoothed. Thus, when the loudness level rapidly changes from a low level to a high level, the processing cannot follow this rapid change and the initial part of the change produces large sounds and then gradually lowers the sounds.

The invention includes two methods for overcoming this problem. One of the methods slightly delays the sound signal itself for which loudness level modification is performed to adjust the signal to the delayed response of the modification coefficients. For this purpose, the FIFO 39 shown in Fig. 5 is required. However, when excessive delay is given to the signal, another problem occurs. In case of television, for example, deviation between images and sounds becomes prominent and the scene looks unnatural. In case of cellular phone or the like, the delay is originally large and a further delay needs to be reduced as much as possible.

The second improving method is the following method as an important part of the invention. This method provides improvement over the response speed of smoothing. The uncomfortableness and the sense of incongruity are particularly felt when small sounds (or no sounds) are rapidly changed to large sounds. In order to cope with this change, the response speed of the loudness level in the rising direction is increased (that is, time constant is decreased), and the response speed in the lowering direction is decreased (that is, time constant is increased) in this example. The following equation shows this relationship. According to the experiments, the uncomfortableness felt when large sounds suddenly change to small sounds is not so great even when the response speed is not increased to the same response speed as in the case when small sounds change to large sounds.

The equation of smoothing is sRq = [(φ-1) × sR(q-1) +Rq] ÷ φ, where: φ=n when Rq-sR(q-1) >0; and φ=N in other cases. In this example, the relation n<N holds. The values n and N are constants indicating degrees of smoothing, and the degrees of smoothing can be converted into time constants by using the following equations. When φ=n, a time constant T1 is calculated from the equation T1 = Δt/{1n(n) - ln(n-1)}. When φ=N, a time constant T2 is calculated from the equation T2 = Δt/{ln(N) - ln(N-1)}. In these equations, In is a generally used operator representing natural logarithm, and Δt is time between digital data corresponding to the inverse number of the sampling rate. When 22.05K sample/sec. in this example, Δt is approximately 45µS. The value sRq obtained from the above recurrence formula becomes a physical quantity representing the sensuous loudness level. Example values of n and N are n=200 and N=2000. In this case, T1=9mS and T2=900mS, which is appropriate for practical use. This is only an example and the values of n and N may be arbitrarily selected such that the results become optimal according to the characteristic of the sound signal.

Then, a coefficient K used for modifying the loudness level is calculated from sRq, and thereafter a signal S obtained from the FIFO 39 is multiplied by the coefficient K to modify the amplitude. The basic procedures of the modifying method are the process for obtaining the modifying coefficient K from sRq indicating the sensuous loudness level, and multiplying each value of the sound data by the coefficient K to obtain each value S' of new sound data. Since the value sRq is a quantity of a bundle of 128 data, this quantity varies stepwise for each 128 data as considered from the original data. Thus, before the coefficient K is used for the modification formula, a coefficient K' interpolated by connecting corners of the stepwise values of K is obtained and substituted in the modification formula. This method is expressed by the equation S'=A×S×K'. The value S is data prior to modification, and the value S' is data after modification.

The basic idea about the coefficient K which is multiplied for modification is that the coefficient K is used to lower the loudness level within a section when the quantity sRq of the sensuous loudness level signal is larger than a reference value. More specifically, the original sound signal S is multiplied by K' which is smaller than 1 to reduce the amplitude of the sound data. Conversely, when sRq is small, the original sound signal S is multiplied by K' which is larger than 1 to increase the amplitude of the sound data. Thus, the value K' is basically so established as to be inversely proportional to sRq with respect to the reference value of sRq.

This modification is effective because the amplitude of the original data (sound signal) S is proportional to sRq. When all the waveforms within the section are similar and the amplitudes are all doubled, for example, the values sRq are also doubled. When the waveforms are similar and all the amplitudes are reduced to half, the values sRq are also half. This is because calculations performed in the processes from DFT until acquisition of sRq are so designed as to have linear relationships.

For example, it is assumed that the value sRq of the sound signal having comfortable loudness level is Z based on examinations. In reversed expression, the loudness level is always comfortable when sRq is kept to Z. However, the sensuous loudness level of the actual sound source is variable. For example, when the value sRq is a large value which is twice larger than the value Z in a certain section, the value sRq becomes the desirable value Z by reducing all the amplitudes within the section to half. This is because the value sRq, which is obtained by applying the same processing as that for calculating sRq to the sound signal (waveform) having the amplitude reduced to half, becomes half of the original value, which is equivalent to the value Z. Conversely, when a small loudness level signal has sRq which is as small as half of the value Z, all the amplitudes of the signal are to be doubled.

However, sRq of the signal after amplitude modification need not be calculated. For easy understanding of the description, the values sRq of the signal after modification obtained when they are calculated are only shown though these values are not needed. Actually, an amplitude modification coefficient K is obtained so as to perform finer modification than the above modification. This modification method is now explained.

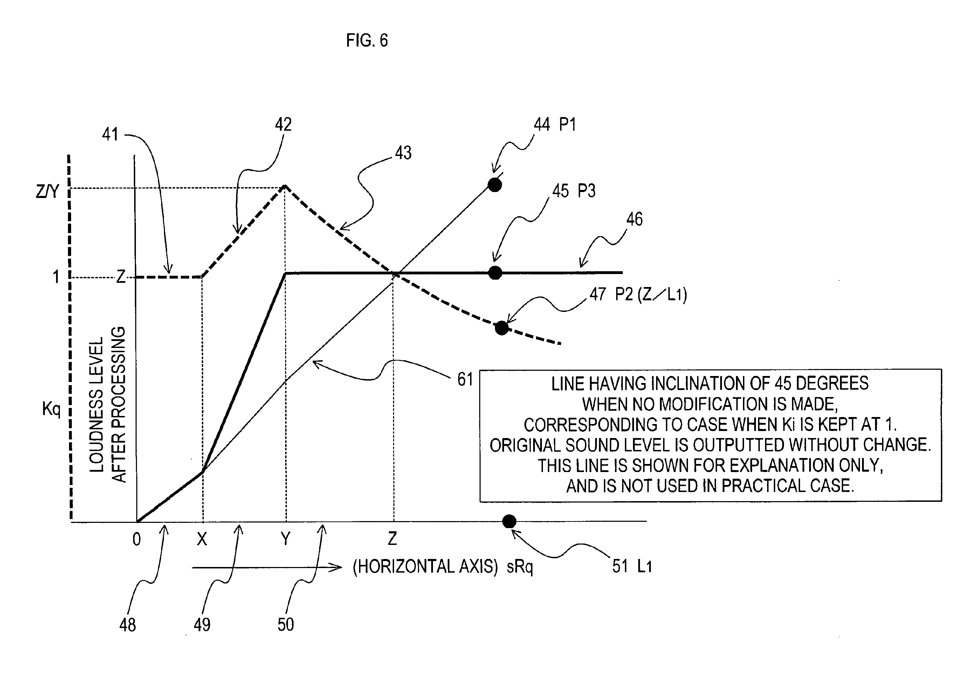

Based on sRq, a modification coefficient Kq for the value q representing the same interval on the time axis is obtained. The relationship between sRq and Kq is now discussed with reference to a graph in Fig. 6. The horizontal axis corresponds to sRq. The vertical axis has overlapping two graphs. The scales on the left side of the vertical axis represent Kq, and the graph is expressed by dotted lines 41, 42 and 43. This graph shows the appropriate values of Kq when sRq on the horizontal axis varies. In this method, a function Kq of sRq is established such that the loudness level after processing coincides with a bold solid line 46. That is, this loudness level after processing can be obtained by setting kq on the lines 41, 42 and 43. For producing the modification coefficient Kq from sRq, the coefficient Kq is divided into three ranges according to the level of sRq, i.e., ranges 48, 49 and 50 in Fig. 6. The graphs corresponding to the respective ranges are the graphs 41, 42 and 43 in Fig. 6.

Equations expressing the graphs 41, 42 and 43 in Fig. 6 are shown below. Initially, the graph 41 in Fig. 6 is expressed by the equation Kq=1 when sRq<X. This graph means that no modification is performed in this range.

The graph 42 in Fig. 6 is expressed by the equation Kq=w×sRq+v when X≤sRq<Y, where constants w and V are expressed by the equations w=(Z-Y)/(Y²-XY) and V=(Y²-XZ)/(Y²-XY).

The graph 43 in Fig. 6 is expressed by the equation Kq=Z/sRq when sRq≥Y. That is, the coefficient Kq is inversely proportional to sRq.

The right axis of the two vertical axes in the graph of Fig. 6 has scales corresponding to the graph 46 indicated by the bold line. The graph 46 indicated by the bold solid line represents sRq to be obtained if new sRq is obtained by applying the same processing as that for obtaining the above sRq to the sound signal after modification (this processing is only assumption for easy understanding of the description, and not required to be performed in practical cases).

For example, it is assumed that a large sound exceeding the level Z desired by the listener and thereafter sRq becomes a level L1 shown by a point 51 on the horizontal axis in Fig. 6. When no modification is performed, the output becomes the same level L1 via a point P1 on the line 44 having an inclination of 45 degrees in the graph. It follows that the same level is outputted since no modification is executed.

In actual cases, modification is performed and the modification coefficient Kq in this case becomes a point P2 on the graph 47. This is expressed by the equation Kq=Z/L1. When the original sound signal having sRq of the level L1 is multiplied by this value Kq, L1×Kq = L1×(Z/L1)=Z holds and thus the value Z results. That is, the sensuous loudness level which has been originally the point P1 on the graph 44 is decreased to the level of Z at the point P3 on the graph 45.

In this case, in the range where sRq is larger than Y, Kq is inversely proportional to sRq. Thus, no matter what level sRq is, all the values of sRq become the Z level if sRq of the sound signal multiplied by Kq is calculated. This secures that the loudness level Z desired by the listener is maintained at all times.

Similarly, Kq is calculated from the equation Kq=w×sRq+v when sRq is a value in the range between X and Y on the graph of Fig. 6, that is, when X≤sRq<Y. This range corresponds to the part 42 on the graph of Fig. 6.

If sRq for the loudness level signal obtained by multiplying the original signal by Kq calculated from this equation is calculated, the value sRq coincides with the bold solid line in the range 49 on the graph. This graph shows that the degree of modification is lowered for sRq having levels lower than Y. That is, the loudness level approaches noise level as the loudness level lowers. On the contrary, sounds become uncomfortable as their amplitude excessively increases.

In the range 48 in Fig. 6 where sRq is smaller than X, Kq is set at 1. This is indicated by the graph 41. In this range, the original sound signal is multiplied by 1 and therefore no modification is performed. When the sound signal is smaller than X, it is determined that the sounds are not sound information to be perceived by humans but just noises, and this part is left unmodified without change from the original. If modification is performed, noises become large sounds and uncomfortable conditions are caused.

Considering from the timing of the original sound data, Kq calculated as above corresponds to one mass of 128 original sound data as discussed above. Thus, when arranged in correspondence with the original sound data, the values of Kq form steps in every 128 pieces of original sound data. Since each of the intervals is as small as 5.8 milliseconds in the form of steps, a serious problem does not occur. In this example, however, interpolation is executed for the stepwise intervals to obtain smoothly varying K', and this value K' is used for the modification formula. In this case, linear interpolation may be used as the interpolation method.

The value K' is expressed by the equation: Ki' = K(q-1)+[{Kq-K(q-1)}+128]×i, where i indicates the order counted from the older data [K(q-1) side] in the 128 data obtained by the interpolating calculation. The counting starts from i=0. The interpolating calculation advances every time calculation of one value Kq finishes. After calculation of the newest Kq is completed, the value Ki' is calculated from the above equation and used for the amplitude modifying calculation.

The value Ki' has a delay since it is calculated from sRq smoothed by the recurrence formula. Thus, modification is applied to a signal (data) Sj at a position delayed by d pieces of data from the newest data. The value d corresponds to the number of stages of the FIFO. Thus, the equation j=i-d holds. The modifying calculation formula is Sj'=A×Sj×K'i, where K'i is data sequentially extracted from the 128 data obtained by interpolation from the Kq-1 side. The value A is a constant for adjusting the overall level. The value Sj' is outputted to the DAC to obtain an analog signal.

The constants used above are now classified and listed to be again described briefly.
b: Constant indicating boundary between the low range and the middle range of frequency. This is represented by the initial number (p) in the middle range.
   (This constant is important when adjusting the sense of loudness level of male and female voices.)
c: Constant indicating the boundary between the middle range and the high range of frequency. This is represented by the initial number (p) in the high range.
   (This constant is important when adjusting the difference in the sense of loudness level between musical sound and non musical sound.)
n: Constant corresponding to the time constant (shorter one) for smoothing when Rq is rising.
N: Constant corresponding to the time constant (longer one) for smoothing when Rq is falling.
A: Constant for determining the overall loudness level.
α: Coefficient for weighting in the low range of frequency.
β: Coefficient for weighting in the middle range of frequency.
γ: Coefficient for weighting in the high range of frequency.
d: Constant for delaying original sound data of modification target (number of stages of FIFO).
X: Limit value for small loudness level. Modification is not performed when sRq is smaller than this value.
Y: All loudness levels larger than the value Y are adjusted to Z.
Z: Reference loudness level desired by the listener.

Optimum values of these constants differ according to the incorporated devices. In case of telephone, for example, the frequency width is originally narrow, and the sound sources are chiefly human voices. In case of television and radio, a number of types of sound sources are used, and the loudness level varies in a wide range. Thus, the constants are selected appropriately for the characteristics of the respective devices, and customized for each of the devices.

Next, the loudness level adjusting method applied to a cellular phone in a fourth embodiment according to the invention is described. Similarly to the third embodiment, an electronic circuit similar to the electronic circuit shown in Fig. 2 providing the loudness level adjusting circuit 20 shown in Fig. 1 is used in the fourth embodiment.

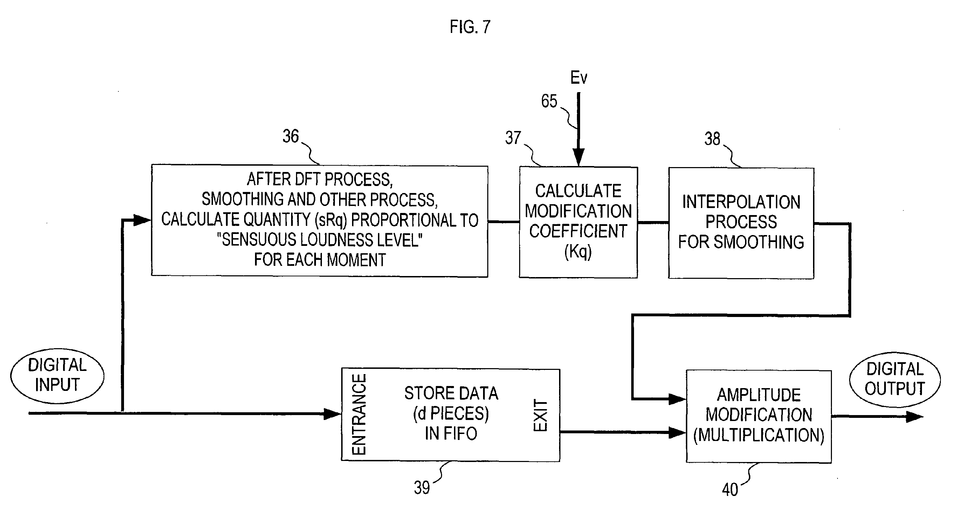

The processing in Fig. 5 used in the third embodiment can be similarly employed in the fourth embodiment. However, an Ev value 65 (described later) indicating the surrounding noise level shown in Fig. 7 which will be described hereinafter is introduced to the modification coefficient calculating device 37. Since only this difference exists, Fig. 7 is additionally given. Fig. 7 is a block diagram showing the concept of processing performed by the DSP shown in Fig. 2 similarly to Fig. 5 relating to the second embodiment. Actually, the processing in Fig. 7 is executed by the DSP shown in Fig. 2 and sequentially performing the following processes.

In case of a cellular phone, there are a wide variety of surrounding noise levels at a spot where the cellular phone is used. Thus, the degree of listening easiness is not always constant even when the loudness level reference set by the listener is fixed. For solving this problem, an example performed in case of the cellular phone is depicted in Figs. 7 through 9, and explained referring to these figures.

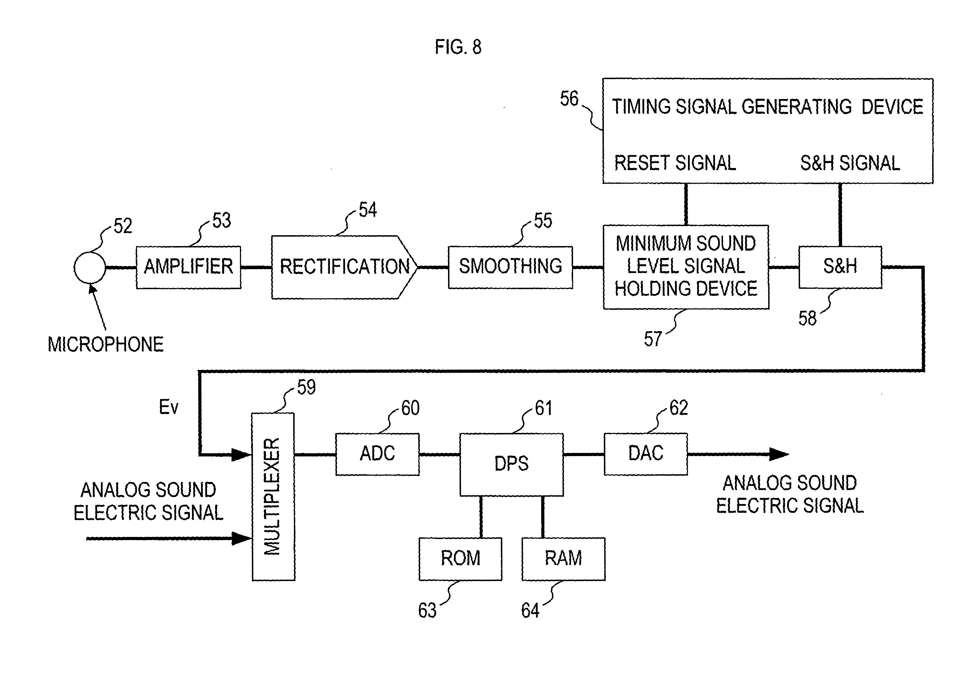

As illustrated in Fig. 8, voice of the user of the cellular phone and surrounding noise are converted into a sound signal by a microphone 52 of the cellular phone, and amplified by an amplifier 53. Then, the signal is rectified by a rectifier 54 and smoothed by smoothing device 55. The output from the smoothing device 55 corresponds to amplitude information of the sound signal. Subsequently, the signal is guided to a minimum loudness level signal holding device 57 which holds the minimum value of the amplitude information as the output from the smoothing device 55. Then, the signal is introduced to a S&H device 58 which samples and holds the output from the minimum loudness level signal holding device 57.

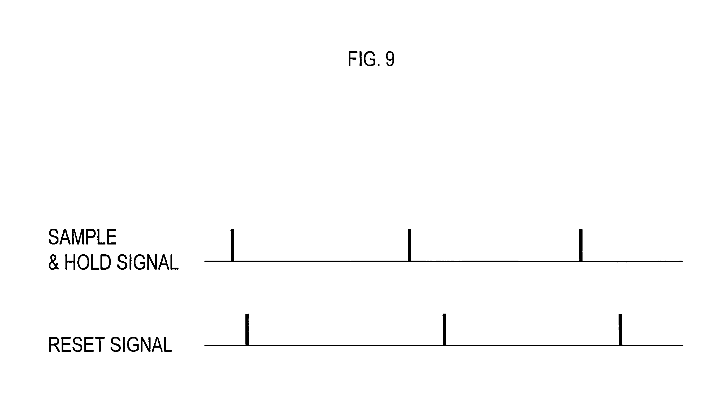

Sampling signal and reset signal having the time relationship shown in Fig. 9 are generated from a timing signal generating device 56. The sampling signal is guided to the S&H device 58 to sample and hold the output signal from the minimum loudness level signal holding device 57. The reset signal resets the operation of the minimum loudness level signal holding device, and starts operation for searching the minimum value in a subsequent new cycle and holding the minimum value.

In case of a cellular phone, a cycle Ts for generating the sampling signal and reset signal shown in Fig. 9 is set at about several seconds. It is preferable to set the cycle Ts at approximately the average intervals of breaths of human speeches, because there is a high possibility that the breath of the speeches by the speaking person of the cellular phone is included in this cycle. The output signal from the smoothing device 55 while the user of the cellular phone is not speaking indicates the level of the sounds surrounding the cellular phone in use. Since no one continues to speak without leaving any extremely short time interval, the loudness level at the stop of speech for a small breath corresponds to the level of surrounding sounds.

The signal thus held by the S&H device 58 is introduced to an ADC 60 through a multiplexer 59, and the digital signal digitized by the ADC 60 is introduced to a DSP 61. The value introduced to the DSP 61 in this step is referred to as an Ev. At the DSP 61, the process shown in Fig. 7 is executed under a program stored in a ROM 63. A RAM 64 is a RAM necessary for operation of the DSP.

The program processing in the loudness level adjusting method according to the fourth embodiment is the same as that in the loudness level adjusting method according to the third embodiment except for the following single difference. The single difference is that the value of the constant Z indicating the loudness level desired by the listener discussed in the third embodiment is not a constant but a function of Ev.

More specifically, since Ev is large at the large level of the surrounding sounds, the value Z established to correspond to the preference of the listener is increased according to the surrounding loudness level. This is expressed by the equation Z=Zo×Ev/Evo. The value Zo is a reference constant and fixed. The value Evo is a reference value for the surrounding loudness level. Thus, when the surrounding loudness level is larger than the reference Evo, the value Z increases by the ratio of Ev/Evo. This relation is reversed when the surrounding loudness level is smaller than the reference Evo.

The same advantage can be offered not only by the above method of substituting the function of Ev for the constant Z, but also by substituting the function of Ev for the constant A in the modification formula S'=A×S×Ki in the amplitude modification of the sound signal performed at the final stage of the processing. In this method, the value A is expressed by the equation A=Ao×Ev/Evo. The value Ao is a reference constant and fixed. The value Evo is the same as above. According to this equation, the value A increases by the ratio of Ev/Evo when the level of the surrounding sounds is larger than the reference loudness level Evo. As a result, the amplitude of the sound signal increases accordingly. This relation is reversed when the surrounding loudness level is smaller than the reference Evo similarly to the above case.

In case of a cellular phone, however, this processing is not sufficient. If the user of the cellular phone continues to speak for a period longer than the above cycle Ts without stop, the value Ev becomes a value equivalent to the minimum value of the loudness level of the voices from the speaking person. In this case, there is a possibility that the value Ev is a value larger than the surrounding noise level. It is thus necessary to insert the subsequent process before performing the process of Z=Zo×Ev/Evo or A=Ao×Ev/Evo.

More specifically, Ev at the small level of the voice from the user of the cellular phone is extracted, and this value Ev is determined as Evm. When Ev<Evm, the above process is performed. However, when Ev>Evm, the value Ev used one value before the above value Ev is substituted for the above value Ev. When the relation Ev>Evm is satisfied from the beginning of communication, the process is performed while setting as Ev=Evo.

By this method, the user of the cellular phone can further adjust the desired loudness level established by himself or herself such that this level is appropriate for the surrounding noise level while listening. Thus, the user can obtain constant listening easiness regardless of variances of surrounding noise. Moreover, the loudness level of the voices from himself or herself is not confused with the level of surrounding sounds.

Furthermore, preferable communication can be achieved without causing any problem even in case of an extraordinarily noisy environment by providing a maximum loudness level holding device as well as the above minimum loudness level signal holding device and using a function approximately proportional to the output signal from the maximum loudness level holding device for the value Evm. In this case, the trouble of confusing voices with the surrounding noise can be avoided when the user of the cellular phone speaks in a loud voice at a highly noisy place.

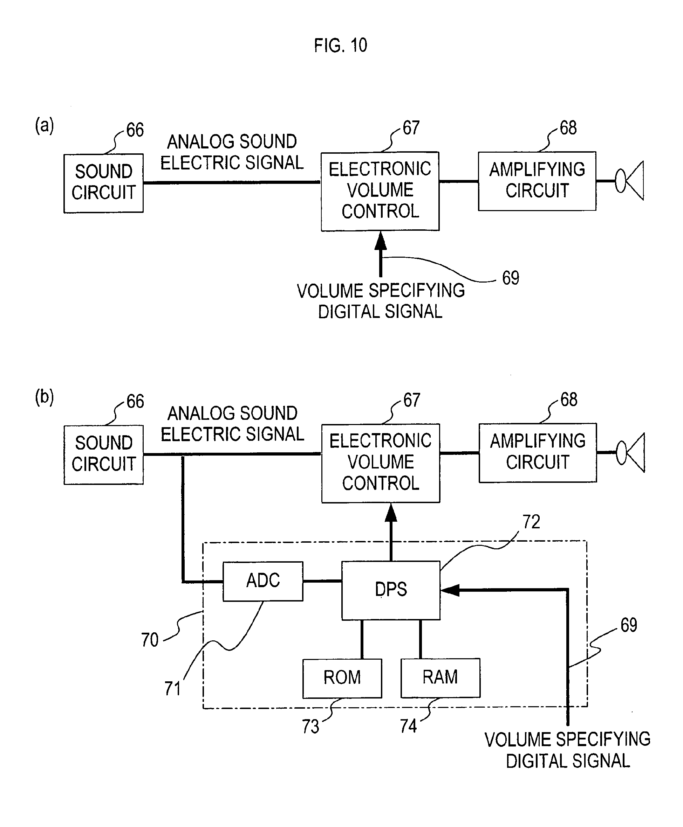

The method of the invention applied to a sound device which already has a device for electrically controlling loudness level using an electronic volume control in a fifth embodiment is now described. The sound device having the electronic volume control generally has a structure shown in the block diagram in Fig. 10(a). More specifically, an electronic volume control 67 is provided between a sound circuit 66 and an amplifier 68 for a speaker or an earphone, and a loudness level specifying digital signal 69 is introduced to the electronic volume control.

According to the fifth embodiment, a block 70 surrounded by an alternate long and short dash line in Fig. 10(b) is added to the structure. The structure shown in Fig. 10(b) is the same as that in Fig. 10(a) except that only the block 70 surrounded by the alternate long and short dash line is added. The block 70 has a number of similarities with the circuit shown in the block diagram in Fig. 2 and chiefly constituted by the DSP. The difference is as follows. According to the structure in Fig. 2, both the processes for extracting the element information signal and for modifying the amplitude of the sound electric signal based on the extracted element information signal are performed by the DSP. However, according to the structure shown in Fig. 10(b), extraction of the element information signal and production of the sensuous loudness level signal are performed by the DSP, and automatic loudness level adjustment of the sound electric signal is executed by modifying the loudness level specifying digital signal 69 for the electronic volume control 67. The signal used for modification is the same value as sRq used in the third embodiment.

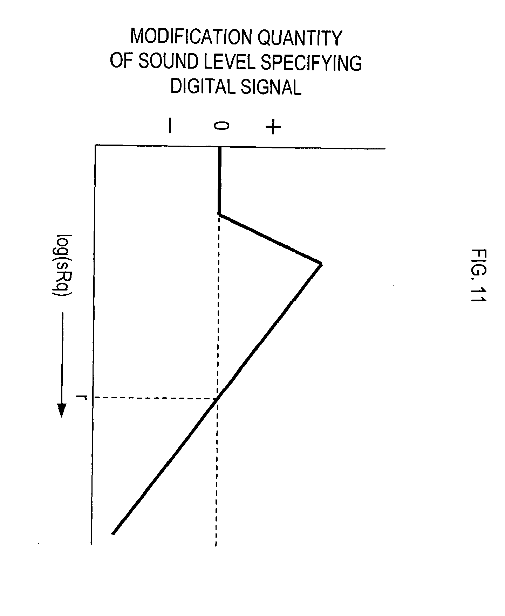

According to the electronic volume control 67, the changes of the loudness level in response to the loudness level specifying digital signal 69 are generally converted into logarithms as one decibel per one step. Thus, the values sRq are converted into logarithms for use. Fig. 11 illustrates this method, which appears to be similar to the method shown in the graph of Fig. 6. The difference between these methods is that the vertical axis indicates the coefficients used for modifying the amplitude of the sound electric signal in Fig. 6, but in Fig. 11 it indicates the coefficients for modifying the loudness level specifying digital signal 69 for the electronic volume control for providing the desired loudness level. In this embodiment, both the vertical and horizontal axes are converted into logarithms.

When a sound inputted from the sound device has a standard loudness level, for example, the value as the logarithm of sRq is set at a value r. When sRq is equivalent to r, the loudness level specifying digital signal is not modified. When a sound having a larger loudness level than r is inputted, the difference between r and sRq is subtracted from the loudness level specifying digital signal set at the desired loudness level, and the resultant signal is transmitted to the electronic volume control 67.

Conversely, when the value as the logarithm of sRq is smaller than r, the difference between r and sRq is added to the established loudness level specifying digital signal and the resultant signal is transmitted to the electronic volume control 67. When sRq is smaller than a certain level in both the graphs in Figs. 11 and 6, the loudness level approaches zero level where no modification is executed. When sRq is further smaller, the modification coefficient is fixed to zero level performing no modification. The reason for this is the same as that in the third embodiment, and therefore the explanation is not repeated herein.

The fifth embodiment is characterized by that the processors used for extracting the element information and producing the sensuous loudness level signal can be those at a low price of which performance is low, and a device for electronic volume control in the existing circuits can be used.

The loudness level adjusting method applied to an actual television receiver in an example according to the invention is now described. A typical television set has a remote controller, and the controller is equipped with a button for silence with no exception. The silence mark and the OFF mark alternately appear on the screen every time this button is pushed, and the corresponding operation is performed. Thus, no sound is generated when the silence condition is selected. When the method according to the invention is applied to this function, the following process is executed.

When the method of the invention is applied to television of the above type, one position switching by the silence button is added and therefore three positions are provided. That is, the three positions of "OFF", "CLSS (Comfortable Loudness Sustaining System)", and "SILENCE" are sequentially selected every time the button is pushed once. Particularly, for watching a war film in the middle of night, CLSS is selected. On the other hand, for enjoying classical music where the difference between strong sound and weak sound is important, OFF is selected.

As apparent from the above description, the invention may be practiced otherwise than as specifically described herein. These changes and modifications are not considered as departing from the spirit and scope of the invention, and any improvements over the invention which are obvious for the skilled in the art are included within the scope of the following claims. Industrial Applicability

When a loudness level adjusting method according to the invention is applied to an electronic circuit of a sound device, the loudness level actually perceived by the listener can be so controlled as to be substantially constant no matter what level the sound signal introduced to the sound device has. Thus, when the method according to the invention is applied to an apparatus containing measures for providing sounds to human ears, this product becomes a "human friendly product". The products to which the method of the invention is applicable are a wide variety of products which are almost all products including a function for generating sounds to be perceived by humans such as television, radio, car stereo, transceiver and the like.

## Claims

1. A loudness level adjusting method for a sound electronic circuit capable of reproducing and outputting a sound electric signal having a predetermined loudness level, the method comprising:
an element information signal extracting step that extracts an element information signal including frequency information based on human sensuous from the sound electric signal for every moment;
a sensuous loudness level signal generating step that includes a smoothing step and generates a sensuous loudness level signal indicating loudness level of the sound electric signal reproduced and perceived by a listener based on the element information signal extracted by the element information signal extracting step;
a loudness level reference setting step that sets a loudness level reference in accordance with preference of the listener of the reproduced sound electric signal; and
at least an amplitude controlling step that controls amplitude of the sound electric signal to be reproduced and outputted such that the difference between the loudness level of the sound electric signal and the loudness level reference set by the loudness level reference setting step can be reduced based on the sensuous loudness level signal generated by the sensuous loudness level signal generating step.

2. The loudness level adjusting method according to claim 1, further comprising an element information signal extracting step that extracts short time average amplitude information or pseudo short time average amplitude information as the element information signal of the sound electric signal.

3. The loudness level adjusting method according to claim 1, further comprising an element information signal extracting step that extracts short time average root mean square value information or pseudo short time average root mean square value information as the element information signal of the sound electric signal.

4. The loudness level adjusting method according to claim 2, wherein the element information signal extracting step includes:
a band dividing step that divides the frequency of the sound electric signal into a plurality of frequency bands;
an energy component extracting step that extracts pseudo energy component corresponding to energy in each of the frequency bands divided by the band dividing step;
a weighting step that weights an intermediate signal processed using a function based on the pseudo energy component in each of the bands extracted by the energy component extracting step; and
an element information signal extracting step that simultaneously extracts both short time average amplitude information or pseudo short time average amplitude information and frequency information.

5. The loudness level adjusting method according to claim 3, wherein the element information signal extracting step includes:
a band dividing step that divides the frequency of the sound electric signal into a plurality of frequency bands;
an energy component extracting step that extracts pseudo energy component corresponding to energy in each of the frequency bands divided by the band dividing step;
a weighting step that weights an intermediate signal processed using a function based on the pseudo energy component in each of the bands extracted by the energy component extracting step; and
an element information signal extracting step that simultaneously extracts both root mean square value information or pseudo root mean square value information and frequency information.

6. The loudness level adjusting method according to claim 2, wherein the element information signal extracting step includes:
a filtering step that has gain characteristics approximately proportional to frequency values in a frequency range which lies within an audio range on a frequency axis and at least lower than the vicinity of a frequency at which the sensuous of an average person becomes the maximum sensitivity; and
an element information extracting step that extracts an element information signal produced by combining two element information signals of short time average amplitude information or pseudo short time average amplitude information and frequency information from an output signal outputted from the filtering step.

7. The loudness level adjusting method according to claim 3, wherein the element information signal extracting step includes:
a filtering step that has gain characteristics substantially proportional to frequency values in a frequency range which lies within an audio range on a frequency axis and at least lower than the vicinity of a frequency at which the sensuous of an average person becomes the maximum sensitivity; and
an element information extracting step that extracts an element information signal produced by combining two element information signals of root mean square value information or pseudo root mean square value information and frequency information from an output signal outputted from the filtering step.

8. The loudness level adjusting method according to claims 1 through 7, wherein the sensuous loudness level signal generating step including the smoothing step contains a smoothing step that has at least two types of smoothing degrees automatically selected according to variation rate of a sensuous loudness level signal prior to smoothing.

9. The loudness level adjusting method according to claims 1 through 8, wherein the loudness level reference setting step includes a sound wave acquiring sound signal generating step that acquires surrounding environment sound wave and converts the acquired sound wave into a sound signal, a minimum loudness level signal acquiring step that acquires a minimum loudness level signal within a predetermined cycle from an output from the sound wave acquiring sound signal generating step, a minimum loudness level signal holding step that holds the minimum loudness level signal acquired by the minimum loudness level signal acquiring step for the predetermined cycle, and a loudness level reference setting altering step that further increases and decreases the loudness level reference set by the loudness level reference setting step in response to the minimum loudness level signal held by the minimum loudness level signal holding step.

10. The loudness level adjusting method according to claims 1 through 8, wherein the loudness level reference setting step includes a sound wave acquiring sound signal generating step that acquires surrounding environment sound wave and converts the acquired sound wave into a sound signal, a minimum loudness level signal acquiring step that acquires a minimum loudness level signal within a predetermined cycle from an output from the sound wave acquiring sound signal generating step, a minimum loudness level signal holding step that holds the minimum loudness level signal acquired by the minimum loudness level signal acquiring step for the predetermined cycle, and a second amplitude controlling step that controls amplitude in response to the minimum loudness level signal held by the minimum loudness level signal holding device as well as a first amplitude controlling step that sets the loudness level in accordance with preference of the listener.

11. A computer program under which a computer executes the loudness level adjusting method according to any one of claims 1 through 10.

12. An information recording medium that records a computer program under which a computer executes the loudness level adjusting method according to any one of claims 1 through 10.

13. A sound electronic circuit that executes the loudness level adjusting method according to any one of claims 1 through 10 using a principle and theory on electronics.

14. A sound electronic circuit capable of reproducing and outputting a sound electric signal having a predetermined loudness level, comprising:
an element information signal extracting device that extracts an element information signal including frequency information based on human sensuous from the sound electric signal for every moment;
an sensuous sound signal generating device that includes a smoothing device and generates a sensuous loudness level signal indicating loudness level of the sound electric signal reproduced and perceived by a listener based on the element information signal extracted by the element information signal extracting device;
a loudness level reference setting device that sets a loudness level reference in accordance with preference of the listener of the reproduced sound electric signal; and
at least one single amplitude controlling device that controls amplitude of the sound electric signal to be reproduced and outputted such that the difference between the loudness level of the sound electric signal and the loudness level reference set by the loudness level reference setting device is reduced based on the sensuous loudness level signal generated by the sensuous loudness level signal generating device.
